# FASCICULE DE BREVET EUROPEEN

(11) **EP 1 208 593 B1**
(45) Date de publication et mention de la délivrance du brevet: **16.02.2011**
(21) Numéro de dépôt: 00958697.5
(22) Date de dépôt: 17.08.2000
(51) Int. Cl.: H01L 21/762, H01L 21/306

(54) **PROCEDE DE TRAITEMENT DE SUBSTRATS POUR LA MICRO-ELECTRONIQUE**
VERFAHREN ZUR BEHANDLUNG EINES HALBLEITERSUBSTRATS
METHOD FOR TREATING SUBSTRATES FOR MICROELECTRONICS

(30) Priorité: 20.08.1999 FR 9910668
(43) Date de publication de la demande: 29.05.2002
(73) Titulaire: S.O.I.Tec Silicon on Insulator Technologies, 38190 Bernin (FR)
(72) Inventeur: BARGE, Thierry, F-38000 Grenoble (FR); GHYSELEN, Bruno, F-38170 Seyssinet (FR); IWAMATSU, Toshiaki, Toyonakam Osaka 560-0874 (JP); NARUOKA, Hideki, Hyougo 664-0864 (JP); FURIHATA, Junichiro, Gunma-ken 379-0196 (JP); MITANI, Kiyoshi, Takasaki-shi Gunma-ken 370-0884 (JP)
(74) Mandataire: Le Forestier, Eric
(86) Numéro de dépôt international: PCT/FR2000/002331
(87) Numéro de publication internationale: WO 2001/015218

(56) Documents cités:
- EP-A- 0 460 437
- EP-A- 0 933 810
- US-A- 4 732 648
- US-A- 5 589 422
- US-A- 5 696 020
- DATABASE WPI Section Ch, Week 200015 Derwent Publications Ltd., London, GB; Class L03, AN 2000-166643 XP002149775 & JP 2000 022159 A (SANYO ELECTRIC CO LTD) , 21 janvier 2000 (2000-01-21)

## Description

L'invention concerne le domaine des procédés de traitement de substrats destinés à la fabrication de composants pour la micro-électronique et/ou pour l'optoélectronique. L'invention porte également sur les substrats obtenus par ce procédé.

Plus précisément, l'invention concerne le domaine des procédés de traitement de substrats entièrement semi-conducteurs (par exemple de silicium) ou entièrement isolants (par exemple de quartz), ou bien encore constitués d'un empilement de couches semi-conductrices ou isolantes. Il peut s'agir de substrats sur lesquels est déposée une couche (par exemple épitaxiale), ou encore de substrats comprenant des structures non homogènes, tels que des substrats comprenant des composants ou des parties de composants à des niveaux plus ou moins avancés de leur élaboration.

Il existe sur une certaine profondeur à partir de la surface d'au moins une face de ces substrats, une couche de matériau qui entre, au moins en partie, dans la constitution des composants réalisés sur cette face. Pour la suite, cette couche sera désignée par l'expression « couche utile ».

La qualité de cette couche utile, et en particulier celle de sa surface, par exemple en terme de rugosité, conditionne celle des composants.

De constantes recherches sont effectuées pour améliorer la qualité de cette couche utile. Le document WO-A-99/53528, par exemple, propose un procédé de polissage par lequel la surface de la couche utile est polie avec un rouleau dont l'axe de rotation est parallèle à cette surface. Cependant, un polissage engendre des défauts, tels que des défauts d'écrouissage, dans la couche de matériau sous jacente à la surface polie.

On connaît également par le document US-A-5 589 422 un procédé d'amélioration d'une couche de semi-conducteur comprenant une succession d'étapes d'oxydation sacrificielle: enchaînées directement les unes avec les autres, de manière à conserver un budget thermique faible et de rester en environnement de travail gazeux.

Un but de l'invention est d'améliorer la qualité de la couche utile d'un substrat semi-conducteur tant en terme de rugosité, qu'en terme de concentration de défauts.

Ce but est atteint, selon l'invention, grâce à un procédé de traitement de substrats pour la micro-électronique ou l'opto-éléctronique tel que défini dans la revendication 1.

Lorsqu'il existe, sur une certaine épaisseur à partir de la surface d'un substrat dont la rugosité n'est pas satisfaisante, une couche de matériau comportant des défauts, la première étape d'oxydation sacrificielle permet de retirer une certaine épaisseur de cette couche comportant des défauts.

Mais cette première étape d'oxydation sacrificielle, qui n'aboutit pas nécessairement au retrait total de la couche comportant des défauts, ne permet généralement pas non plus de réduire de manière suffisante, la rugosité de la surface l'ayant subie. La première étape d'oxydation sacrificielle est alors utilement complétée d'une étape de polissage permettant d'obtenir la rugosité souhaitée.

La deuxième étape d'oxydation sacrificielle permet ensuite, de manière analogue à la première, d'ôter en particulier la couche dans laquelle l'étape de polissage a introduit des défauts et/ou le reste de la couche comportant des défauts. Cependant, partant cette fois-ci d'une surface polie, la rugosité de la face du substrat, après la deuxième étape d'oxydation sacrificielle, est satisfaisante et compatible avec l'utilisation de la couche utile dans des applications en micro- ou opto-électronique.

La couche dans laquelle se trouve la majorité des défauts générés par le polissage est généralement d'une épaisseur supérieure à 100 (10 Å = 1 nm). Avantageusement alors, on retirera, grâce à la deuxième étape d'oxydation sacrificielle, une couche de matériau sur une épaisseur comprise entre 400 Å et 1000 Å.

On comprend donc que l'invention consiste en une combinaison d'étapes d'oxydation sacrificielle et de polissage. Chacune de ces étapes participe au retrait de la partie de la couche utile comportant une concentration de défauts trop importante, la deuxième étape d'oxydation sacrificielle participant éventuellement plus spécifiquement à la guérison des défauts générés par l'étape de polissage.

Ce procédé est plus avantageux qu'un polissage seul. Ainsi, comme indiqué plus haut, la deuxième étape d'oxydation sacrificielle permet d'ôter la zone dans laquelle le polissage a introduit des défauts. Mais de plus, elle permet de limiter d'autres effets néfastes du polissage. En effet, si l'on part d'une couche de défauts relativement épaisse, il faut un long polissage pour l'ôter. Or un long polissage abouti généralement à un manque d'uniformité en épaisseur. Cet inconvénient est d'autant plus critique que l'épaisseur de matériau à enlever est importante et donc que l'étape de polissage est longue. C'est le cas notamment lorsque l'épaisseur à retirer atteint 150 à 200 nm. En outre, de longs polissages ralentissent l'exécution du procédé et induisent une baisse de productivité. La première étape d'oxydation sacrificielle, permet d'éviter ces inconvénients en limitant le polissage essentiellement à ce qui est nécessaire pour réduire la rugosité, puisque cette première étape d'oxydation sacrificielle a contribué de manière non négligeable à retirer la partie de la couche utile comportant une forte concentration de défauts. De plus en réduisant le polissage nécessaire, les défauts engendrés par celui-ci peuvent être développés à moins grande échelle.

Le procédé conforme à la présente invention permet donc, par une combinaison particulière d'étapes consistant à retirer du matériau par oxydation sacrificielle et par polissage, d'obtenir une couche utile de qualité améliorée, c'est à dire dont la concentration en défauts est réduite, et ayant en outre une rugosité de surface optimisée. Ceci tout en conservant une épaisseur de substrat uniforme, et un rendement optimal.

Le procédé selon l'invention est avantageusement mis en ouvre pour améliorer la qualité d'une couche utile en matériau oxydable, tel que du silicium.

Dans ce cas, la première étape d'oxydation sacrificielle comprend une étape d'oxydation du matériau oxydable, sur au moins une partie de l'épaisseur de ce matériau comportant des défauts, et une étape de désoxydation du matériau ainsi oxydé.

La deuxième étape d'oxydation sacrificielle comprend une étape d'oxydation du matériau oxydable, sur une certaine épaisseur de matériau dans lequel l'étape de polissage a introduit des défauts et une étape de désoxydation du matériau ainsi oxydé.

Avantageusement alors, le procédé selon l'invention comprend en outre avant et/ou après l'étape de polissage, une étape de recuit du substrat.

Si une étape de recuit du substrat est réalisée avant l'étape de polissage, l'étape d'oxydation de la première étape d'oxydation sacrificielle est avantageusement apte à former, avant la fin de cette étape de recuit, une couche d'oxyde protégeant le reste du substrat pendant au moins une partie du recuit. Dans ce cas, la couche d'oxyde protège le reste du substrat de certains effets nuisibles du recuit, tel que le phénomène de piquage, aussi appelé « pitting », observé à la surface de certains semi-conducteurs lorsque ceux-ci sont recuits sous atmosphère non oxydante (azote, argon, vide, etc.). Ce phénomène de piquage se produit dans le cas du silicium en particulier lorsque celui-ci est à nu, c'est à dire lorsqu'il n'est pas du tout recouvert d'oxyde.

Mais réciproquement, le recuit permet de guérir les défauts occasionnés par l'oxydation.

Si une étape de recuit du substrat est réalisée après l'étape de polissage, l'étape d'oxydation de la deuxième étape d'oxydation sacrificielle est avantageusement apte à former avant la fin de cette étape de recuit, une couche d'oxyde protégeant le reste du substrat.de la même manière que ce qui a été décrit pour la première oxydation sacrificielle.

Le procédé selon l'invention est aussi avantageusement mis en oeuvre pour améliorer la qualité d'une couche utile en matériau peu oxydable. Dans la suite et en particulier dans les revendications, on utilisera indifféremment le qualificatif oxydable, que le matériau dit oxydable soit facilement oxydable ou peu oxydable.

D'autres aspects, buts et avantages de l'invention apparaîtront à la lecture de la description détaillée qui suit. L'invention sera aussi mieux comprise en référence à cette description considérée conjointement avec les dessins annexés dans lesquels :
- les figures 1A à 1F représentent l'évolution d'un substrat (vu en coupe) au cours de son traitement par un premier mode de mise en oeuvre du procédé selon l'invention ;
- la figure 2 est un diagramme représentant les densités d'atomes implantés et de défauts générés par l'implantation dans un substrat préparé par l'une des variantes du procédé SMART-CUT^{®}, en fonction de la distance par rapport à la surface bombardée au cours de l'implantation ;
- la figure 3 représente un organigramme du procédé illustré par la figure 1 ;
- la figure 4 est une représentation schématique en coupe d'un substrat 1 ayant subi une étape d'oxydation dans le cadre du procédé illustré par la figure 3 ;
- la figure 5 est une représentation schématique de l'évolution d'un substrat (vu en perspective) au cours de la deuxième étape d'oxydation sacrificielle du procédé illustré par la figure 3 ;
- la figure 6 représente l'organigramme d'un deuxième mode de mise en oeuvre du procédé selon l'invention ;
- la figure 7 est une représentation schématique de la réalisation d'une structure capacitive sur un substrat (vu en coupe), ayant subi ou non la deuxième étape d'oxydation sacrificielle, conformément au procédé illustré par la figure 6 ;
- la figure 8 représente schématiquement l'évolution d'un substrat, vu en coupe, au cours de son traitement par la technique dite SECCO ;
- la figure 9 est un diagramme représentant la densité superficielle de défauts révélés par la technique illustrée à la figure 8, en fonction de l'épaisseur de la couche restant après la première étape de cette technique ; et
- la figure 10 est une représentation schématique de l'évolution du bord d'un substrat au cours de la deuxième étape d'oxydation sacrificielle du procédé décrit par la figure 6.

La présente invention est décrite de manière détaillée ci-dessous dans le cadre particulier mais non limitatif d'un procédé de fabrication de substrats, appelé procédé « SMART-CUT^{®}».

Une manière particulière de mettre en oeuvre le procédé SMART-CUT^{®} est décrit par exemple dans le document FR 2 681 472.

Il s'agit d'un procédé de fabrication de substrats comportant une couche ou un film mince de semi-conducteur sur une de leurs faces.

Selon l'une de ses variantes, le procédé SMART-CUT^{®} comporte :
- une étape d'implantation d'atomes, sous une face d'une plaque de semi-conducteur, dans une zone d'implantation ;
- une étape de mise en contact intime de la face de la plaque soumise à l'implantation, avec un substrat support et ;
- une étape de clivage de la plaque au niveau de la zone d'implantation, pour transférer la partie de la plaque située entre la surface soumise à l'implantation et la zone d'implantation, sur ledit substrat support et former un film mince ou une couche de semi-conducteur sur celui-ci.

Par implantation d'atomes, on entend tout bombardement d'espèces atomiques ou ioniques, susceptible d'introduire ces espèces dans un matériau, avec un maximum de concentration de ces espèces dans ce matériau, ce maximum étant situé à une profondeur déterminée par rapport à la surface bombardée. Les espèces atomiques ou ioniques sont introduites dans le matériau avec une énergie également distribuée autour d'un maximum. L'implantation des espèces atomiques dans le matériau peut être réalisée grâce à un implanteur par faisceau d'ions, un implanteur par immersion dans un plasma, etc. Par clivage, on entend toute fracture du matériau implanté au niveau du maximum de concentration, dans ce matériau, des espèces implantées ou au voisinage de ce maximum. Cette fracture n'intervient pas nécessairement selon un plan cristallographique du matériau implanté.

Dans une application particulière de ce procédé, on réalise une couche de silicium sur isolant, aussi appelée SOI (acronyme de l'expression anglo-saxonne « Silicon on Insulator »).

Plusieurs manières peuvent être envisagées pour réaliser une couche de silicium sur isolant, selon le procédé SMART-CUT^{®} .

Selon une première manière, on peut par exemple, recouvrir une plaque de silicium sur sa face d'implantation, d'une couche d'oxyde isolant, et utiliser un substrat support, par exemple aussi en silicium, pour le transfert.

Selon une deuxième manière, on peut avoir une couche complètement semi-conductrice que l'on transfère soit sur un substrat support recouvert d'une couche d'isolant, soit sur un substrat support complètement isolant (ex. : quartz).

Selon une troisième manière, on peut avoir un isolant sur la plaque de semi-conducteur, et transférer une couche de cette plaque, soit sur un substrat support recouvert lui aussi d'isolant, soit sur un substrat complètement isolant.

Après clivage et transfert, on obtient dans tous les cas une structure SOI avec une couche transférée sur une face du substrat support, la surface libre de cette couche correspondant à une surface de clivage. Il est alors avantageux d'utiliser le procédé conforme à la présente invention pour réduire la rugosité de cette surface de clivage et la densité de défauts de la couche transférée.

Ces défauts peuvent être révélés par diverses techniques (dites « WRIGHT », « SECCO », « SCHIMMEL »., etc., du nom de leur inventeur). Pour la suite nous ne considérerons que les défauts révélés par la technique SECCO.

Plusieurs modes de mise en oeuvre du procédé selon l'invention vont être décrits ci-dessous, dans le cadre particulier mais non limitatif du procédé SMART-CUT^{®}, appliqué à la réalisation d'une structure SOI.

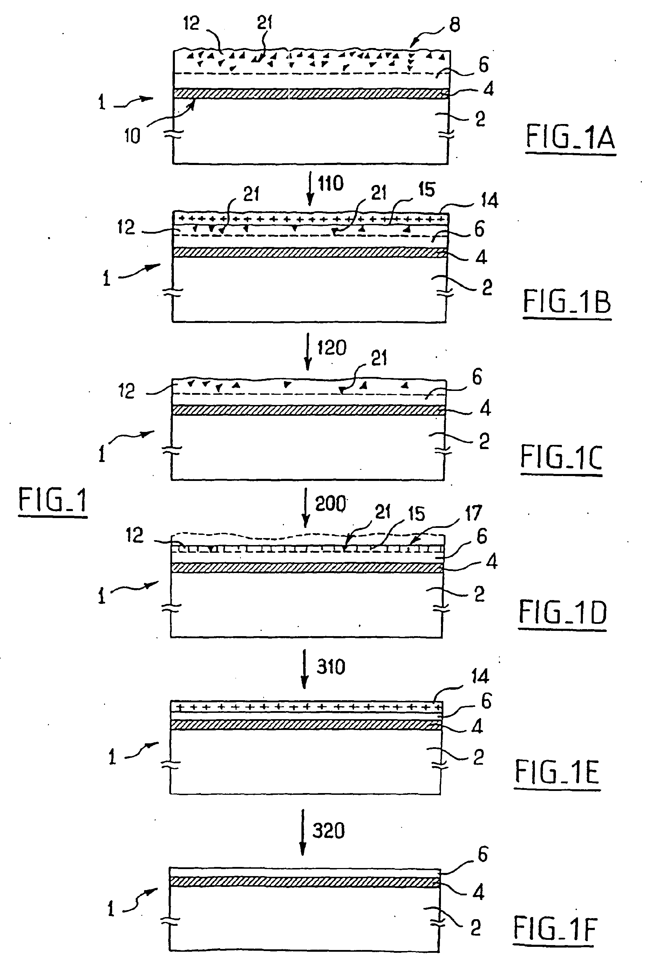

Une telle structure SOI est représentée schématiquement sur la figure 1A. Elle consiste en un substrat 1 qui comporte un support 2. en silicium, une couche d'isolant 4 en oxyde de silicium et une couche mince 6 de silicium sur le support 2.

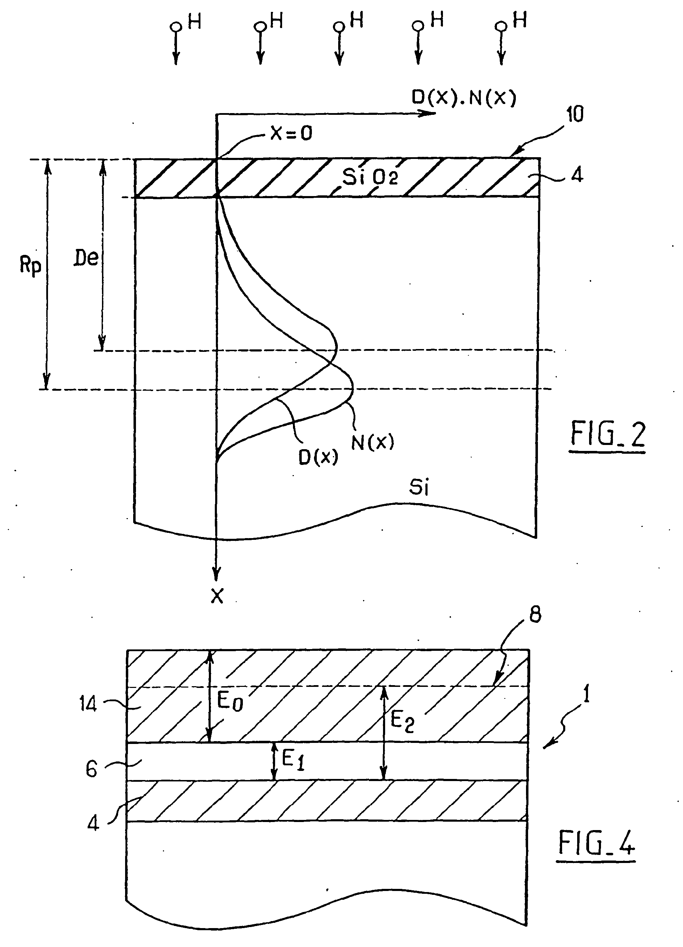

La couche d'isolant 4 est prise en sandwich entre le support 2 et la couche mince 6. Cette couche d'isolant 4 peut provenir de l'oxydation du support 2 et/ou de la couche mince 6. Après clivage et transfert de la couche mince 6 sur le support 2, la surface libre de cette couche mince 6 correspond à une surface de clivage 8 qui présente une rugosité que l'on souhaite réduire. De plus, sur une certaine épaisseur, la couche mince 6 présente, à partir de cette surface de clivage 8, une zone de défauts 12. Ces défauts sont des défauts créés au cours de l'étape d'implantation d'atomes et par le clivage (arrachements de matière par exemple). Ces défauts sont représentés, sur la figure 1, sous forme de triangles. Ils seront nommés ci-dessous, défauts d'implantation et clivage 21. La génération de défauts d'implantation et clivage 21 est schématiquement illustrée par le diagramme de la figure 2. Les atomes, par exemple d'hydrogène, implantés avec une certaine énergie se distribuent dans le matériau implanté au voisinage d'une surface située à une certaine profondeur Rp par rapport à la face d'implantation 10. Cette surface correspond au maximum du profil de la concentration N(x) en atomes implantés dans le matériau en fonction de la distance x par rapport à la face implantée 10. La distribution de la concentration N(x) en atomes implantés autour de ce maximum, situé à une distance Rp de la face 10, diminue progressivement en partant de cette surface sur une certaine distance de part et d'autre de celle-ci. Par exemple, pour une implantation d'hydrogène à 300 nm, cette distance est approximativement de 80 nm de part et d'autre de Rp. Mais comme illustré par la figure 2, le maximum de la densité de défauts D(x) en fonction de la profondeur x à partir de la face implantée 10 est situé à une distance De, par rapport à cette face implantée 10, inférieure à la distance Rp.

Notons qu'il faudra éventuellement, dans le cadre de l'invention, implanter les atomes avec une plus grande énergie au cours du procédé SMART-CUT^{®}, que dans le cadre de ses mises en oeuvre conjointement aux procédés de l'art antérieur, de manière à pouvoir éliminer la quantité de matériau présentant une forte concentration D(x) de défauts, tout en conservant une couche mince 6 finale ayant l'épaisseur voulue.

La fracture s'effectuant au voisinage de la surface située à la distance Rp de la face implantée 10, la majorité des défauts 15, 21 se trouve dans la couche mince 6, transférée sur le support 2. Il doit être compris que le « voisinage » n'indique pas nécessairement une zone répartie de manière approximativement équivalente de part et d'autre de la profondeur située à la distance Rp. La fracture peut s'effectuer globalement plutôt dans la partie située entre la face implantée 10 et la surface située à la profondeur Rp de cette face implantée 10. Mais elle peut également s'effectuer globalement plutôt dans la partie située au delà de la surface située à la profondeur Rp de la face implantée 10, par rapport à cette face implantée 10. Comme illustré par la figure 1A, après clivage et transfert, la face implantée 10 se trouve enterrée et la surface de clivage 8 est libre. Les défauts d'implantation et clivage 21 se trouvent donc dans la zone de défauts 12 située au voisinage de cette surface de clivage 8.

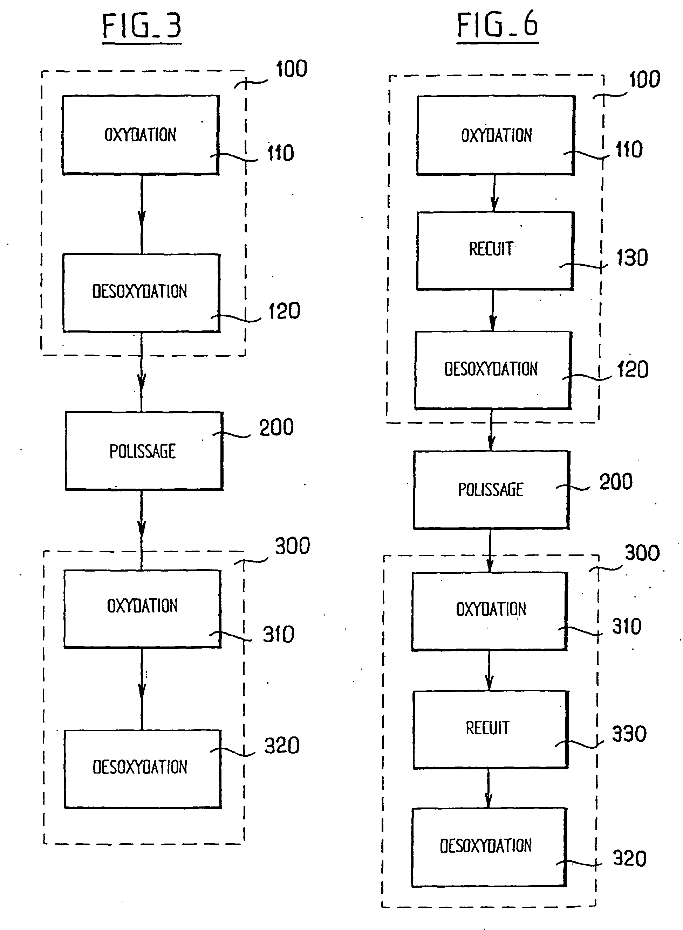

Selon un premier mode de mise en oeuvre du procédé conforme à la présente invention, celui-ci comprend les étapes représentées sur l'organigramme de la figure 3. Ce procédé comprend une première étape d'oxydation sacrificielle 100, suivie d'une étape de polissage 200, elle-même suivie d'une deuxième étape d'oxydation sacrificielle 300. Chaque étape d'oxydation sacrificielle 100, 300 se décompose en une étape d'oxydation 110, 310 suivie d'une étape de désoxydation 120, 320.

Chaque étape d'oxydation 110, 310 est préférentiellement réalisée à une température comprise entre 700°C et 1100°C. L'oxydation 110, 310 peut être réalisée par voie sèche ou par voie humide. Par voie sèche, l'oxydation 110, 310 est par exemple menée en chauffant le substrat sous oxygène gazeux. Par voie humide, l'oxydation 310, 320 est menée en chauffant le substrat 1 dans une atmosphère chargée en vapeur d'eau. Par voie sèche ou par voie humide, l'atmosphère d'oxydation peut également être chargée en acide chlorhydrique, selon les méthodes classiques connues de l'homme du métier.

La voie humide est préférée car elle introduit, dans la structure cristalline, moins de défauts de type fautes d'empilement, défauts « HF » (on appelle défaut « HF », un défaut dont la présence est révélée par une auréole de décoration dans l'oxyde enterré de la structure SOI, après traitement de cette structure dans un bain d'acide fluorhydrique), etc.

Chaque étape de désoxydation 120, 320 est préférentiellement réalisée en solution. Cette solution est par exemple une solution d'acide fluorhydrique à 10 ou 20%. Pour enlever mille à quelques milliers d'Angströms d'oxyde, le substrat 1 est plongé dans une telle solution pendant quelques minutes.

Le substrat 1 subit alors l'étape de polissage 200. Ce polissage 200 est réalisé par voie mécano-chimique, selon les techniques connues de l'homme du métier.

Après le polissage 200, le substrat 1 est soumis à la deuxième oxydation sacrificielle 300. Celle-ci est analogue à la première oxydation sacrificielle 100. Le polissage 200 contribue, avec chaque étape d'oxydation sacrificielle 100, 300, à retirer de la matière, et en particulier de la matière comprenant des défauts.

L'évolution du substrat 1 au cours de ce procédé est représentée schématiquement sur les figures 1A à 1F.

Après la première étape d'oxydation 110, décrite plus haut, une couche d'oxyde 14 est formée au voisinage de la surface de clivage 8 (fig. 1 B). Cette couche d'oxyde 14 est représentée schématiquement de manière plus détaillée sur la figure 4. Cette couche d'oxyde 14 d'une épaisseur E₀ est d'un volume plus important que celui correspondant au silicium oxydé. Le « fantôme » de la position de la surface de clivage 8 est représenté sur la figure 4 par des traits pointillés. On remarque que la somme de l'épaisseur E₁ de la couche mince 6 de silicium restant entre la couche d'isolant 4 et la couche d'oxyde 14, et de l'épaisseur E₀ de ladite couche d'oxyde 14, est supérieure à l'épaisseur E₂ de la couche mince 6 de silicium avant oxydation.

Après la première étape d'oxydation 110, le substrat 1 subit une étape de désoxydation 120 visant à ôter la couche d'oxyde 14.

A l'issue de la première oxydation sacrificielle 100, la zone de défauts 12 est en grande partie, mais généralement pas totalement, éliminée. De plus, la rugosité initiale de la surface de clivage 8, quoique réduite par cette première oxydation sacrificielle 100, demeure encore trop importante (Fig.1C).

Le substrat 1 est donc soumis à l'étape de polissage 200.

Comme représenté schématiquement sur la figure 1D, le polissage 200 permet de réduire encore la rugosité de la surface libre de la couche mince 6. A l'issue de cette étape de polissage 200, la rugosité est très faible. Mesurée au microscope à force atomique, cette rugosité est de l'ordre de 1Å rms (rms est l'acronyme de l'expression anglo-saxonne. « root mean square » qui désigne une valeur quadratique moyenne).

Cependant, un polissage mécano-chimique engendre des défauts d'écrouissage 15 sur une certaine profondeur de matériau, sous la surface polie 17.

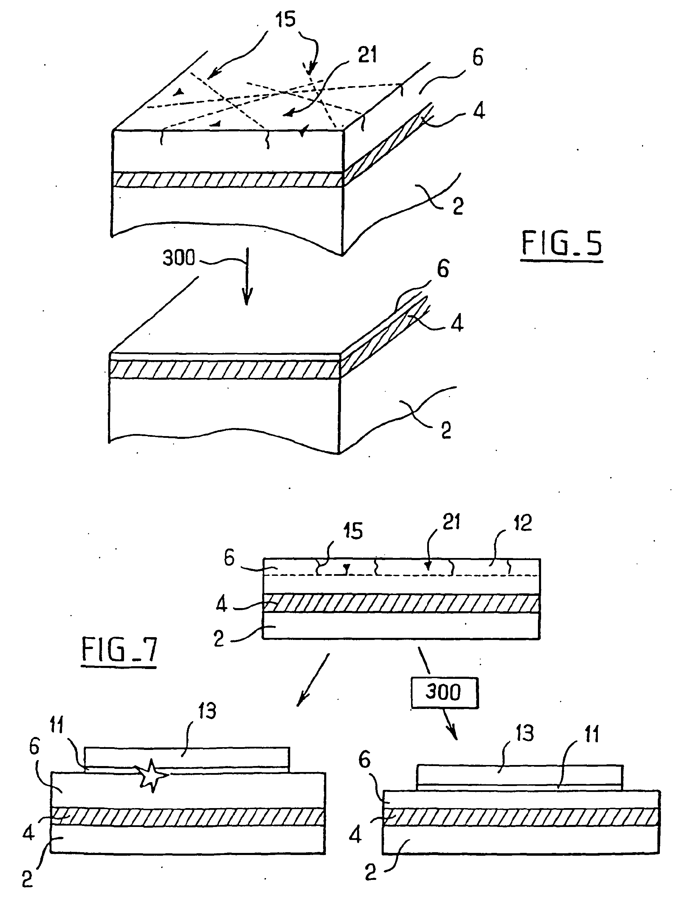

L'écrouissage est dépendant de paramètres évolutifs, telle que la pression du tampon de polissage sur le substrat 1, l'usure de ce tampon, etc. Les défauts d'écrouissage 15 sont visibles en surface en microscopie (microscopie à force atomique par exemple) sous forme de rayures qui sont en fait constituées par des alignements de défauts cristallins, révèlables par la méthode de révélation de type SECCO. Mais en plus de ces défauts d'écrouissage 15 générés par le polissage, il reste encore essentiellement des défauts d'implantation et clivage 21. L'ensemble de ces défauts est schématiquement illustré par la figure 5. Les défauts d'écrouissage 15 générés par le polissage sont représentés par des traits en pointillés et les défauts d'implantation et clivage 21, restant après la première oxydation sacrificielle 100 et le polissage 200, sont représentés par des triangles.

Le substrat 1 est alors soumis à une deuxième oxydation sacrificielle 300 visant à retirer la matière comprenant les défauts 15 générés sous l'effet du polissage 200, ainsi que les défauts d'implantation et clivage 21 restants, de la couche mince 6 après clivage (fig.1D et 1F).

Cette deuxième oxydation sacrificielle 300 est analogue à la première. Mais partant d'une surface polie, la surface libre de la couche mince 6, après l'étape de désoxydation 320 (fig.1F), présente une rugosité satisfaisante.

On obtient, à l'issue de ce premier mode de mise en oeuvre du procédé conforme à la présente invention, un substrat 1 avec une structure SOI dans laquelle la concentration de défauts de la couche mince 6 a été considérablement réduite.

Selon un deuxième mode de mise en oeuvre du procédé selon l'invention, illustré par la figure 6, chaque oxydation sacrificielle comporte une étape de recuit (130, 330) du substrat 1.

Comme pour le premier mode de mise en oeuvre du procédé selon l'invention, ce deuxième mode de mise en oeuvre est décrit ci-dessous en association avec le procédé SMART-CUT^{®} appliqué à la fabrication de structures SOI.

On désigne par recuit toute opération thermique destinée à améliorer les qualités du matériau de la couche utile 6. Ce recuit 130, 330 peut être un traitement thermique effectué à température constante ou à température variable. Dans ce dernier cas, le recuit 130, 330 peut être réalisé par exemple avec une augmentation progressive de la température entre deux valeurs, ou avec une oscillation cyclique entre deux températures, etc.

Préférentiellement, le recuit 130, 330 est effectué au moins en partie à une température supérieure à 1000°C et plus particulièrement vers 1100-1200°C.

Préférentiellement, le recuit 130, 330 est réalisé sous atmosphère non oxydante. Cette atmosphère peut comprendre de l'argon, de l'azote, de l'hydrogène, etc., ou encore un mélange de ces gaz. Le recuit 130, 330 peut également être réalisé sous vide. Aussi, préférentiellement, pour protéger le reste de la couche mince 6 pendant le recuit 130, 330 et éviter le phénomène de piquage décrit plus haut, l'étape d'oxydation 110, 310 de chaque oxydation sacrificielle 100, 300 est réalisée avant l'étape de recuit 130, 330. Selon une variante avantageuse du procédé selon l'invention, l'oxydation débute avec le début de la montée en température du recuit 130, 330, et se termine avant la fin de ce dernier.

L'étape de recuit 130, 330 du substrat 1 permet de guérir la couche mince 6 des défauts engendrés au cours des étapes précédentes du procédé de fabrication et préparation de ce substrat 1. Plus particulièrement, l'étape de recuit 130, 330 peut être effectuée pendant une durée et à une température, telles qu'on réalise, par celui-ci, une guérison de défauts cristallins, tels que des fautes d'empilement, des défauts HF, etc., engendrés dans la couche mince 6, au cours de l'étape de formation de chaque couche d'oxyde 14.

Chaque étape de recuit 130, 330 présente en outre l'avantage de renforcer l'interface de collage entre la couche mince 6 transférée au cours du procédé SMART-CUT^{®}, et son support 2.

La densité de défauts restant dans la couche mince 6 est là encore considérablement diminuée après le traitement du substrat 1 par la variante du procédé selon l'invention, illustrée par la figure 6.

Des mesures électriques ont été réalisées pour comparer en particulier l'amélioration des propriétés électriques apportée par la deuxième oxydation sacrificielle 300. A cette fin et comme représenté schématiquement sur la figure 7, des structures capacitives ont été réalisées sur la surface libre de la couche mince 6, de substrats 1 ayant subis ou non la deuxième oxydation sacrificielle 300.

Dans les deux cas, la structure capacitive simule un oxyde de grille. Elle est constituée d'une couche d'oxyde isolante 11 formée sur la surface libre de la couche mince 6 et d'une électrode 13 déposée sur cette couche d'oxyde isolante 11.

On compare alors la tension de claquage mesurée sur ces structures capacitives à celle mesurée sur des structures capacitives réalisées sur un matériau « sans défaut », c'est à dire n'ayant subi ni implantation, ni clivage. On constate alors que les structures capacitives réalisées sur les structures SOI n'ayant pas subi de deuxième oxydation sacrificielle 300 ou ayant subi une deuxième oxydation sacrificielle 300 formant et retirant 50 nm d'oxyde, présentent une fréquence de défaillance (claquage) plus élevée que des structures capacitives réalisées sur un matériau « sans défaut » ; alors que les structures capacitives réalisées sur les structures SOI ayant subi une deuxième oxydation sacrificielle 300 formant et retirant 200 nm d'oxyde, présentent une fréquence de défaillance (claquage) comparable à celle des structures capacitives réalisées sur un matériau « sans défaut ». La notion de fréquence de défaillance recouvre le fait que l'on observe de manière imprévisible, lors des tests des structures capacitives décrites ci-dessus, un claquage, dans les mêmes conditions que celles classiques d'utilisation avec une certaine fréquence. Autrement dit, on n'a pratiquement pas plus de structures capacitives défaillantes réalisées sur un matériau ayant subi une deuxième oxydation sacrificielle 300 formant et retirant 200 nm d'oxyde que de structures capacitives défaillantes réalisées sur un matériau « sans défaut ».

Ceci montre que la couche mince 6 après avoir subi le procédé selon l'invention, avec une deuxième oxydation sacrificielle 300 comprenant un recuit 330, retirant une épaisseur suffisante de matériau, ne présente pratiquement plus de défauts.

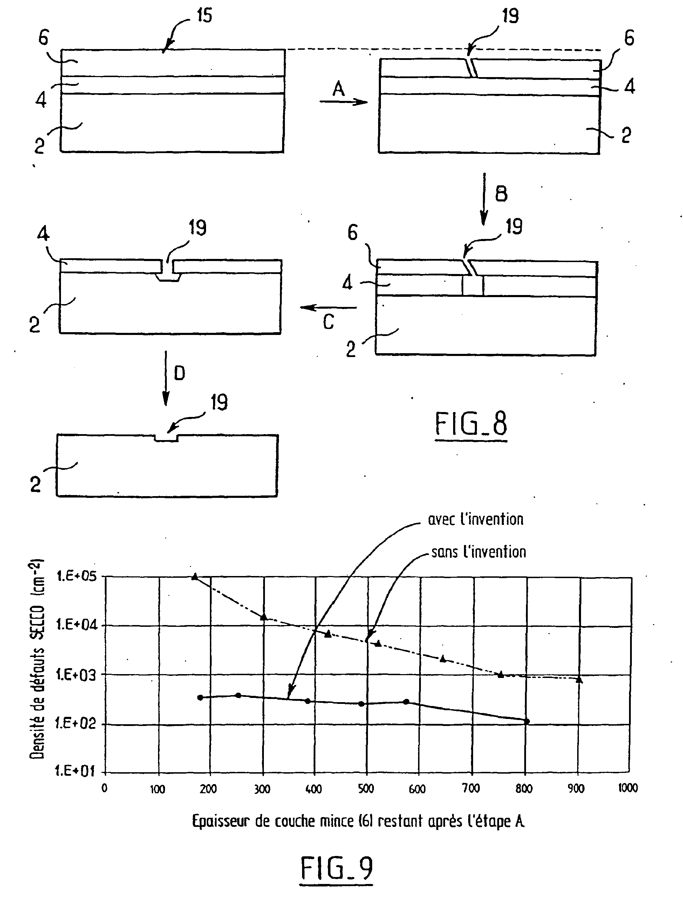

La concentration de défauts peut être déterminée en les révélant grâce à une solution de type SECCO dont la composition est connue par l'homme du métier. Ainsi, partant d'un substrat 1 SOI constitué de 2000 Å de silicium sur 4000 Å d'oxyde de silicium, une technique standard de révélation des défauts grâce à une solution de type SECCO est illustrée sur la figure 8. Elle comprend :
- une étape A consistant à immerger le substrat 1, pendant 12 à 23 secondes, dans une solution de type SECCO, pour graver 1100 à 1900 Å de silicium de la couche mince 6 et graver sélectivement plus rapidement cette couche mince 6 au niveau des défauts cristallins du matériau (comprenant entre autres ceux générés par le polissage 200), jusqu'à ce que des trous 19 correspondant aux emplacements de ces défauts débouchent sur la couche d'isolant 4 ;
- une étape B consistant à immerger le substrat 1 dans une solution d'acide fluorhydrique pour graver, en les élargissant dans la couche d'isolant 4, les trous 19 réalisés à l'étape précédente ;
- une étape C consistant à immerger à nouveau le substrat 1 dans une solution de type SECCO pour ôter le reste de la couche mince 6 et propager les trous 19 dans le support 2 ; et
- une étape D consistant à immerger à nouveau le substrat 1 dans une solution d'acide fluorhydrique pour supprimer totalement la couche d'isolant 4.

Les trous 19, restants dans le support 2 sont d'une dimension suffisante pour pouvoir être comptés sous microscope.

Notons que l'épaisseur de couche mince 6 restant après l'étape A doit être particulièrement bien contrôlée car la détermination de la densité de défauts par la technique décrite ci-dessus y est très sensible.

La figure 9 représente des comptages de trous 19 ainsi révélés en fonction de l'épaisseur de couche mince 6 restant après l'étape A sur des substrats 1 ayant subi ou non une deuxième oxydation sacrificielle 300 accompagnée d'un recuit 330 conformément au procédé selon l'invention. Plus précisément, comme chaque point correspond à une densité de défauts déterminée sous microscope, pour une épaisseur de couche mince 6 restant après l'étape A, il faut comprendre que plus l'épaisseur de cette couche mince 6 restante diminue, plus on révèle de défauts. Donc pour une concentration en volume, de défauts, qui serait constante sur toute l'épaisseur de la couche mince 6, la courbe correspondante devrait être décroissante vers les grandes épaisseurs de couche mince 6 restant après l'étape A.

La courbe supérieure correspond à des mesures réalisées sur un substrat 1 avec 3 650 Å de couche mince 6 transférée, ayant subi une oxydation sacrificielle avec recuit (ôtant 650 Å de couche mince 6), suivie d'un polissage (ôtant 950 Å de couche mince 6) pour aboutir à une couche mince 6 de 2050 Å, avant traitement par la technique SECCO exposée ci-dessus. On constate sur cette courbe une forte remontée vers les faibles épaisseurs de couche mince 6 restant après l'étape A. Elle est représentative des défauts de surface induits par le polissage 200.

La courbe inférieure correspond à des mesures réalisées sur un substrat 1 avec 4 300 Å de couche mince 6 transférée ayant subi, avant traitement par la technique SECCO exposée ci-dessus, le procédé selon l'invention, comprenant une première oxydation sacrificielle 100 avec recuit (ôtant 650 Å de couche mince 6), suivie d'un polissage 200 (ôtant 950 Å de couche mince 6) et d'une deuxième oxydation sacrificielle avec recuit 300 (ôtant 650 Å de couche mince 6), pour aboutir également à une couche mince 6 de 2050 Å. On constate que la forte remontée vers les faibles épaisseurs de couche mince 6 restant après l'étape A figurant sur la courbe supérieure, a disparu. Il n'y a donc pratiquement plus de défauts 15 induits par le polissage 200 dans la couche utile 6 après que le substrat 1 ait subi le procédé selon l'invention. On remarque également que le niveau de base de la courbe inférieure se situe environ un ordre de grandeur au-dessous du niveau de base de la courbe supérieure. Ceci peut être attribué au fait que l'on a mieux éliminé, grâce au procédé conforme à la présente invention, les défauts résiduels provenant de l'implantation et du clivage.

La densité surfacique de défauts SECCO mesurée sur le substrat 1 ayant subi le procédé selon l'invention, est inférieure à 5.10²cm² sur toute la gamme d'épaisseur de couche mince 6 restante.

Donc, dans le cas de la réalisation d'un substrat 1 SOI par le procédé SMART-CUT^{®}, on ôtera, avantageusement, grâce à la deuxième oxydation sacrificielle 300, une couche de silicium comportant des défauts générés par le polissage 200 comprenant une concentration de défauts correspondant à des densités surfaciques de défauts SECCO supérieures à 5.10² cm⁻², lorsque la couche mince 6 est issue d'un substrat avec, par exemple, une couche mince de silicium à faible densité de défaut.

On obtiendrait des résultats analogues avec, par exemple une couche mince de silicium épitaxié, de silicium recuit sous hydrogène, ou de silicium dit « low COPs », c'est à dire à faible densité de défauts « COPS » (de l'acronyme de l'expression anglosaxonne « Crystal Originated Particles), ou encore de silicium FZ ou CZ à faible taux de défauts « COPs ».

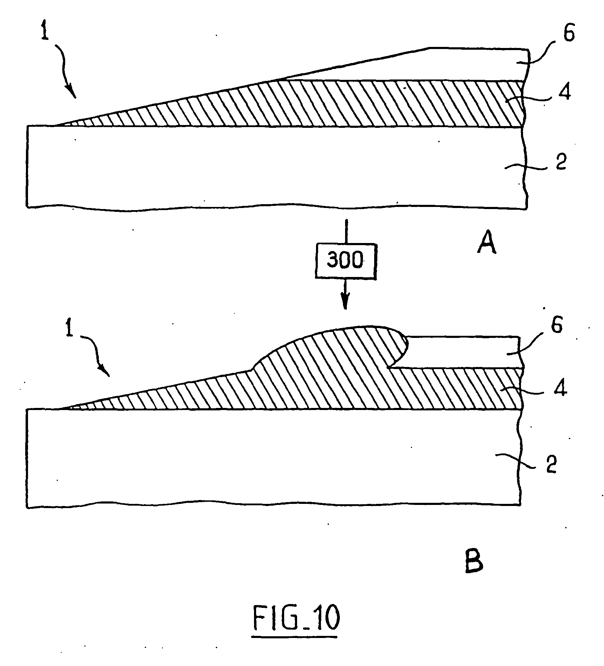

De manière surprenante, il a été constaté en outre, que le deuxième mode de mise en oeuvre du procédé selon l'invention décrit ci-dessus, permet d'éliminer le phénomène dit des « tombées de bord » de l'oxyde enterré formant l'isolant 4 et de la couche mince 6. Ce phénomène des tombées de bord se manifeste avec des substrats 1 SOI préparés avec les procédés de type SMART-CUT^{®}, de l'art antérieur, ne comportant pas de deuxième oxydation sacrificielle 300, par le détachement de débris et particules, provenant de l'oxyde enterré et de la couche mince 6. En effet, comme illustré schématiquement sur la figure 10A, la couche d'oxyde enterré formant l'isolant 4 et la couche mince 6 présentent, après la première oxydation sacrificielle 100, à proximité du bord du substrat 1, un aspect biseauté. La pointe de chacune de ces couches 4, 6, et plus particulièrement celle de la couche mince 6 transférée, est susceptible de se séparer du substrat 1, au cours des différentes étapes technologiques de fabrication de composants électroniques ou optoélectroniques sur ces substrats 1.

Mais comme illustré sur la figure 10B, après la deuxième oxydation sacrificielle 300 de l'oxyde se forme en particulier sur la pointe de la couche mince 6, en continuité avec la couche d'oxyde enterré formant l'isolant 4. Ceci permet essentiellement d'éviter la présence d'une pointe au bord de la couche mince 6, fragile et aisément détachable de l'oxyde enterré formant l'isolant 4 sous-jacent.

Les premier et deuxième modes de mise en oeuvre du procédé selon l'invention décrits ci-dessus, concernent des applications visant à améliorer la qualité de couches minces 6 de silicium sur isolant, obtenues par le procédé « SMART-CUT^{®} ». On a décrit plus particulièrement le deuxième mode de mise en oeuvre du procédé selon l'invention dans le cadre de son applications à une structure SOI constituée d'une couche mince 6 d'environ 2000 Å de silicium, sur une couche d'isolant 4 de 4000 Å d'oxyde de silicium. Pour obtenir une couche mince 6 de cette épaisseur, il faut implanter des atomes d'hydrogène avec une énergie comprise entre 70 et 100 keV. Pour obtenir des couches 6 plus épaisses, il faudra implanter ces atomes plus profondément, c'est à dire avec une énergie plus élevée. Cependant, plus les atomes sont implantés profondément, plus la distribution de la concentration de ces atomes dans la couche 6 sera étalée et plus la concentration de défauts liés à l'implantation le sera aussi. L'épaisseur de matériau comprenant des défauts, à retirer par le procédé conforme à la présente invention sera alors plus importante. Les épaisseurs citées ci-dessus ne sont donc en rien limitatives.

On comprendra également que le procédé selon l'invention peut être mis en oeuvre dans le cadre d'autres applications. D'une manière générale, le procédé selon l'invention est utile chaque fois que l'on souhaite éliminer une couche superficielle en conservant la qualité du matériau sous-jacent. Comme mentionné plus haut, dans le mode de mise en oeuvre du procédé comprenant une étape de recuit 130, 330, le recuit peut avoir un effet de guérison qui peut même permettre d'améliorer la qualité de ce matériau sous-jacent.

Le procédé selon l'invention a été décrit ci-dessus en prenant pour exemple illustratif, le cas du silicium, mais il doit être compris que ce qui a été exposé ci-dessus est tout à fait transposable pour d'autres matériaux, et en particulier d'autres matériaux semi-conducteurs, que le silicium.

Il a été décrit ci-dessus un exemple de mode de mise en oeuvre du procédé selon l'invention, dans lequel chaque oxydation sacrificielle comporte une étape de recuit du substrat. Mais il doit être compris que l'on ne sortira pas du cadre de l'invention si seulement l'une des oxydations sacrificielles comporte une étape de recuit. Ainsi, selon d'autres exemples de mise en oeuvre du procédé selon l'invention seulement la première ou la deuxième oxydation sacrificielle comporte une étape de recuit, analogue à celle décrite ci-dessus.

## Revendications

1. Procédé pour améliorer la qualité structurelle d'un substrat (1) pour la micro-électronique ou l'optoélectronique, le substrat comportant une couche utile (6) destinée notamment à la réalisation de circuits et au moins en partie composée d'un matériau semi-conducteur oxydable, ladite couche étant exposée au niveau d'une face du substrat et possédant des premiers défauts (21) au voisinage de ladite face, le procédé comprenant en succession :
- une première étape d'oxydation sacrificielle (100) pour retirer en surface de la couche utile (6) une certaine épaisseur du matériau constitutif de celle-ci et une partie au moins des premiers défauts (21),
- une étape de polissage (200) de la face de la couche utile ayant subi la première étape d'oxydation sacrificielle (100), ladite étape engendrant des deuxièmes défauts (15) notamment par écrouissage dans la couche utile au voisinage de ladite face, et
- une deuxième étape d'oxydation sacrificielle (300) pour retirer à nouveau en surface de la couche utile (6) une certaine épaisseur du matériau constitutif de celle-ci et une partie au moins des deuxièmes défauts (15).

2. Procédé selon la revendication 1 **caractérisé par le fait que** la première étape d'oxydation sacrificielle (100) comprend une sous-étape d'oxydation (110) du matériau semi-conducteur, sur au moins une partie de l'épaisseur de ce matériau comportant les premiers défauts (21), et une sous-étape d'enlèvement (120) du matériau ainsi oxydé.

3. Procédé selon l'une des revendications précédentes **caractérisé par le fait que** la deuxième étape d'oxydation sacrificielle (300) comprend une sous-étape d'oxydation (310) du matériau oxydable, sur au moins une partie de l'épaisseur de matériau comportant les deuxièmes défauts (15), et une sous-étape d'enlèvement (320) du matériau ainsi oxydé.

4. Procédé selon l'une des revendications 2 et 3, **caractérisé par le fait qu'**au moins une étape d'oxydation sacrificielle (100, 300) comporte en outre une étape de recuit (130, 330) du substrat (1).

5. Procédé selon la revendication 4, **caractérisé par le fait que** chaque sous-étape d'oxydation (110, 310) de chaque étape d'oxydation sacrificielle (100, 300) est apte à former avant la fin de l'étape de recuit (130, 330), une couche d'oxyde (14) protégeant le reste du substrat (1).

6. Procédé selon l'une des revendications précédentes, **caractérisé par le fait que** l'on ôte, grâce à la deuxième étape d'oxydation sacrificielle (300), une couche de matériau sur une épaisseur supérieure à 100 Å.

7. Procédé selon la revendication 6, **caractérisé par le fait que** l'on ôte, grâce à la deuxième étape d'oxydation sacrificielle (300), une couche de matériau sur une épaisseur comprise entre 400 Å et 1000 Å.

8. Procédé de fabrication d'un substrat (1) pour la micro-électronique ou l'opto-éléctronique, comportant une couche utile (6) destinée notamment à la réalisation de circuits et au moins en partie composée d'un matériau semi-conducteur oxydable, ladite couche étant exposée sur l'une des faces du substrat, le procédé comprenant :
- une étape d'implantation d'atomes, sous une face d'une plaque de semi-conducteur destinée à former la couche utile, dans une zone d'implantation,
- une étape de mise en contact intime de la face de la plaque, soumise à l'implantation, avec un substrat support (2),
- une étape de clivage de la plaque, au niveau de la zone d'implantation, pour transférer une partie de la plaque sur le substrat support (2) et former sur celui-ci un film mince formant la couche utile (6),
- une première étape d'oxydation sacrificielle (100) pour retirer en surface de la couche utile (6) une certaine épaisseur du matériau constitutif de celle-ci,
- une étape de polissage (200) de la face de la couche utile ayant subi la première étape d'oxydation sacrificielle (100), et
- une deuxième étape d'oxydation sacrificielle (300) pour retirer à nouveau en surface de la couche utile (1) une certaine épaisseur du matériau constitutif de celle-ci.

9. Procédé selon l'une des revendications précédentes, **caractérisé par le fait que** la couche utile (6) est en silicium.

10. Procédé selon la revendication 9, **caractérisé par le fait que** l'on ôte, grâce à la deuxième étape d'oxydation sacrificielle (300), une couche de silicium comprenant une concentration de défauts correspondant à des densités surfaciques de défauts supérieures à 5.10² cm⁻².

## Claims

1. Process for improving the structural quality of a substrate (1) for microelectronics or optoelectronics, the substrate comprising a working layer (6) intended in particular for the production of circuits and at least partially composed of an oxidizable semiconductor material, the said layer being exposed on one face of the substrate and having first defects (21) in the vicinity of the said face, the process comprising, in succession:
- a first sacrificial oxidation stage (100) for removing, at the surface of the working layer (6), a certain thickness of the material constituting the latter and a portion at least of the first defects (21),
- a stage of polishing (200) the face of the working layer which has been subjected to the first sacrificial oxidation stage (100), the said stage generating second defects (15), in particular by work hardening, in the working layer in the vicinity of the said face, and
- a second sacrificial oxidation stage (300) for again removing, at the surface of the working layer (6), a certain thickness of the material constituting the latter and a portion at least of the second defects (15).

2. Process according to Claim 1, **characterized in that** the first sacrificial oxidation stage (100) comprises a sub-stage of oxidation (110) of the semiconductor material, over at least a portion of the thickness of this material comprising the first defects (21), and a sub-stage of taking off (120) the material thus oxidized.

3. Process according to either of the preceding claims, **characterized in that** the second sacrificial oxidation stage (300) comprises a sub-stage of oxidation (310) of the oxidizable material, over at least a portion of the thickness of material comprising the second defects (15), and a sub-stage of taking off (320) the material thus oxidized.

4. Process according to either of Claims 2 and 3, **characterized in that** at least one sacrificial oxidation stage (100, 300) additionally comprises a stage of annealing (130, 330) the substrate (1).

5. Process according to Claim 4, **characterized in that** each oxidation sub-stage (110, 310) of each sacrificial oxidation stage (100, 300) is capable of forming, before the end of the annealing stage (130, 330), an oxide layer (14) which protects the remainder of the substrate (1).

6. Process according to one of the preceding claims, **characterized in that** a layer of material is removed, by virtue of the second sacrificial oxidation stage (300), over a thickness of greater than 100 Å.

7. Process according to Claim 6, **characterized in that** a layer of material is removed, by virtue of the second sacrificial oxidation stage (300), over a thickness of between 400 Å and 1000 Å.

8. Process for the manufacture of a substrate (1) for microelectronics or optoelectronics, comprising a working layer (6) intended in particular for the preparation of circuits and at least partially composed of an oxidizable semiconductor material, the said layer being exposed on one of the faces of the substrate, the process comprising:
- a stage of implanting atoms in an implantation region under a face of a semiconductor wafer intended to form the working layer,
- a stage of bringing the face of the wafer which has been subjected to the implantation into intimate contact with a backing substrate (2),
- a stage of cleaving the wafer at the level of the implantation region in order to transfer a portion of the wafer onto the backing substrate (2) and to form, on the latter, a thin film forming the working layer (6),
- a first sacrificial oxidation stage (100) for removing, at the surface of the working layer (6), a certain thickness of the material constituting the latter,
- a stage of polishing (200) the face of the working layer which has been subjected to the first sacrificial oxidation stage (100), and
- a second sacrificial oxidation stage (300) for again removing, at the surface of the working layer (1), a certain thickness of the material constituting the latter.

9. Process according to one of the preceding claims, **characterized in that** the working layer (6) is made of silicon.

10. Process according to Claim 9, **characterized in that** a layer of silicon comprising a concentration of defects corresponding to surface densities of defects of greater than 5 x 10² cm⁻² is removed by virtue of the second sacrificial oxidation stage (300).

## Patentansprüche

1. Verfahren zur Verbesserung der strukturellen Qualität eines Substrats (1) für die Mikroelektronik oder die Optoelektronik, wobei das Substrat eine Nutzschicht (6) umfasst, die insbesondere zur Herstellung von Schaltungen vorgesehen ist und die wenigstens teilweise aus einem oxidierbaren Halbleitermaterial besteht, wobei die Schicht im Bereich einer Fläche des Substrats offen liegend ist und erste Defekte (21) benachbart zu dieser Fläche hat, wobei das Verfahren nacheinander Folgendes umfasst:
- eine erste Phase der Opferoxidation (100) zum oberflächlichen Abtragen der Nutzschicht (6) auf einer bestimmten Dicke des diese bildenden Materials sowie wenigstens eines Teils der ersten Defekte (21),
- eine Phase zum Polieren (200) der Fläche der Nutzschicht, auf die die erste Phase der Opferoxidation (100) eingewirkt hat, wobei diese Phase benachbart zu dieser Fläche zweite Defekte (15) erzeugt, insbesondere durch Kaltumformung in der Nutzschicht, und
- eine zweite Opferoxidationsphase (300) zum erneuten oberflächlichen Abtragen der Nutzschicht (6) auf einer bestimmten Dicke des diese bildenden Materials sowie wenigstens eines Teils der zweiten Defekte (15).

2. Verfahren nach Anspruch 1, **dadurch gekennzeichnet, dass** die erste Phase der Opferoxidation (100) Folgendes umfasst: eine Unterphase zur Oxidation (110) des Halbleitermaterials über wenigstens einen Teil der Dicke dieses Materials, der die ersten Defekte (21) beinhaltet, sowie eine Unterphase zum Entfernen (120) des derart oxidierten Materials.

3. Verfahren nach einem der vorhergehenden Ansprüche, **dadurch gekennzeichnet, dass** die zweite Phase der Opferoxidation (300) Folgendes umfasst: eine Unterphase zur Oxidation (310) des oxidierbaren Materials über wenigstens einen Teil der Dicke dieses Materials, der die zweiten Defekte (15) beinhaltet, sowie eine Unterphase zum Entfernen (320) des derart oxidierten Materials.

4. Verfahren nach einem der Ansprüche 2 und 3, **dadurch gekennzeichnet, dass** wenigstens eine Opferoxidationsphase (100, 300) außerdem eine Phase zum Tempern (130, 330) des Substrats (1) umfasst.

5. Verfahren nach Anspruch 4, **dadurch gekennzeichnet, dass** jede Oxidationsunterphase (110, 310) jeder der Opferoxidationsphasen (100, 300) dafür eingerichtet ist, vor dem Ende der Temperphase (130, 330), eine Oxidschicht (14) zu bilden, die den Rest des Substrats (1) schützt.

6. Verfahren nach einem der vorhergehenden Ansprüche, **dadurch gekennzeichnet, dass** durch die zweite Opferoxidationsphase (300) eine Materialschicht auf einer Dicke von mehr als 100 Â entfernt wird.

7. Verfahren nach Anspruch 6, **dadurch gekennzeichnet, dass** durch die zweite Opferoxidationsphase (300) eine Materialschicht auf einer Dicke zwischen 400 Â und 1000 Â entfernt wird.

8. Herstellungsverfahren für ein Substrat (1) für die Mikroelektronik oder die Optoelektronik, das eine Nutzschicht (6) umfasst, die insbesondere zur Herstellung von Schaltungen vorgesehen ist und die wenigstens teilweise aus einem oxidierbaren Halbleitermaterial besteht, wobei die Schicht auf einer der Flächen des Substrats offen liegend ist und wobei das Verfahren Folgendes umfasst:
- eine Phase der Implantation von Atomen unter einer Fläche einer Halbleiterplatte, die dafür vorgesehen ist, die Nutzschicht zu bilden, in einer Implantationszone,
- eine Phase des Herstellens eines engen Kontakts der Plattenfläche, die der Implantation ausgesetzt war, mit einem Trägersubstrat (2),
- eine Phase der Spaltung der Platte im Bereich der Implantationszone, um einen Teil der Platte auf das Trägersubstrat (2) zu übertragen und auf dieser einen dünnen Film zu bilden, der die Nutzschicht (6) bildet,
- eine erste Phase der Opferoxidation (100) zum oberflächlichen Abtragen der Nutzschicht (6) auf einer bestimmten Dicke des diese bildenden Materials,
- eine Phase zum Polieren (200) der Fläche der Nutzschicht, auf die die erste Opferoxidationsphase (100) eingewirkt hat, und
- eine zweite Opferoxidationsphase (300) zum erneuten oberflächlichen Abtragen der Nutzschicht (1) auf einer bestimmten Dicke des diese bildenden Materials.

9. Verfahren nach einem der vorhergehenden Ansprüche, **dadurch gekennzeichnet, dass** die Nutzschicht (6) aus Silizium besteht.

10. Verfahren nach Anspruch 9, **dadurch gekennzeichnet, dass** durch die zweite Opferoxidationsphase (300) eine Siliziumschicht entfernt wird, die eine Defektkonzentration hat, die Oberflächendefektdichten von mehr als 5.10² cm⁻² entspricht.
